# FASCICULE DE BREVET EUROPEEN

(11) **EP 3 472 631 B1**
(45) Date de publication et mention de la délivrance du brevet: **31.08.2022**
(21) Numéro de dépôt: 17740050.4
(22) Date de dépôt: 14.06.2017
(51) Int. Cl.: G01R 15/18, G01R 22/06

(54) **DISPOSITIF DE COMPTAGE D'ÉNERGIE ÉLECTRIQUE**
ELEKTRIZITÄTSZÄHLERVORRICHTUNG
ELECTRICITY METERING DEVICE

(30) Priorité: 20.06.2016 FR 1655734
(43) Date de publication de la demande: 24.04.2019
(73) Titulaire: Gulplug, 38000 Grenoble (FR)
(72) Inventeur: POIRON, Vianney, 38000 Grenoble (FR)
(74) Mandataire: INNOV-GROUP
(86) Numéro de dépôt international: PCT/FR2017/051540
(87) Numéro de publication internationale: WO 2017/220887

(56) Documents cités:
- EP-A1- 2 354 799
- US-A1- 2010 264 906

## Description

### Domaine technique de l'invention

La présente invention se rapporte à un dispositif de comptage d'énergie électrique destiné à être associé à un conducteur électrique pour générer des données de mesure liées au courant électrique qui traverse ledit conducteur électrique et les envoyer par exemple vers une station centrale distante à travers un réseau de communication sans-fil. Le dispositif de l'invention présente l'avantage d'être autonome en énergie électrique en s'alimentant par induction grâce au courant électrique qui circule dans le conducteur électrique.

### Etat de la technique

Les solutions de gestion d'énergie électrique en vue d'améliorer l'efficacité énergétique d'une infrastructure sont de plus en plus présentes et nécessitent la détermination de l'énergie électrique consommée par chaque équipement de l'infrastructure. Pour cela, on utilise notamment différents types de dispositifs qui sont judicieusement placés en différents points de l'infrastructure en vue de mesurer les courants électriques et éventuellement de déterminer d'autres paramètres. Les différentes données de mesure sont envoyées à une station centrale distante à travers un réseau de communication sans-fil. Certains dispositifs connus permettent de collecter et de déterminer des informations précises. Or, on s'est aperçu que, dans la plupart des applications, la précision des informations n'était pas décisive et qu'une simple estimation de l'énergie électrique consommée présentait déjà un intérêt certain, ouvrant ainsi la voie au développement de dispositifs simples et donc peu coûteux. Ces dispositifs sont ainsi de simples dispositifs de comptage d'énergie électrique.

La demande de brevet EP2354799A1 décrit un tel dispositif de comptage d'énergie électrique qui comporte :
- Un capteur de courant agencé pour fournir un courant secondaire à partir d'un courant électrique primaire circulant dans un conducteur électrique,
- Une unité de stockage d'énergie électrique connectée audit capteur de courant et agencée pour stocker une quantité d'énergie électrique à partir du courant électrique secondaire,
- Une unité de détection à seuil de tension connectée à ladite unité de stockage d'énergie électrique principale et agencée pour détecter un dépassement d'un seuil de tension aux bornes de l'unité de stockage d'énergie électrique,
- Une unité de traitement connectée à ladite unité de stockage d'énergie électrique,
- Un émetteur de données sans-fil couplé à ladite unité de traitement et permettant d'envoyer un message contenant des données représentatives du courant électrique circulant dans ledit conducteur électrique,
- Des moyens de commutation commandés par l'unité de détection à seuil de tension pour déclencher une alimentation électrique de l'unité de traitement et dudit émetteur lorsque ledit seuil de tension aux bornes de l'unité de stockage d'énergie électrique principale est dépassé pour émettre un message contenant des données représentatives du courant électrique circulant dans ledit conducteur électrique.

Ce dernier dispositif présente l'avantage d'être d'un fonctionnement simple, non intrusif et de ne nécessiter que d'une faible quantité d'énergie électrique pour fonctionner.

D'autres dispositifs de comptage d'énergie sans-fils et autonomes en énergie électrique sont également connus des documents WO2008/142425 ou WO2010/119332.

Les dispositifs décrits dans ces documents sont adaptés pour l'émission de message à destination de stations centrales présentes localement et ne permettent pas l'émission de message vers des stations plus éloignées, par exemple à travers un réseau de communication longue distance et bas-débit de type LPWAN (pour « Low Power Wide Area Network ») et se basant sur un protocole tel que LoRaWAN (« pour Long Range Wide-area network ») ou celui développé par les société SigFox ou Qowisio.

Le but de l'invention est de proposer un dispositif de comptage d'énergie électrique qui puisse émettre des messages sur des réseaux cellulaires bas débit et longue portée telle que ceux définis ci-dessus, tout en permettant de conserver une solution de comptage simple de l'énergie électrique.

### Exposé de l'invention

Ce but est atteint par un dispositif de comptage d'énergie électrique sans-fil comportant :
- un capteur de courant agencé pour fournir un courant secondaire à partir d'un courant électrique primaire circulant dans un conducteur électrique,
- une unité de stockage principale d'énergie électrique connectée audit capteur de courant et agencée pour stocker une quantité d'énergie électrique à partir du courant électrique secondaire,
- une unité de détection à seuil de tension connectée à ladite unité de stockage d'énergie électrique principale et agencée pour détecter un dépassement d'un seuil de tension aux bornes de l'unité de stockage d'énergie électrique principale,
- une unité de traitement connectée à ladite unité de stockage principale,
- des premiers moyens de commutation commandés par l'unité de détection à seuil de tension et configurés pour déclencher une alimentation électrique de l'unité de traitement lorsque ledit seuil de tension aux bornes de l'unité de stockage d'énergie électrique principale est dépassé,
- un premier émetteur de données sans-fil couplé à ladite unité de traitement et configuré pour envoyer un message contenant des données représentatives du courant électrique circulant dans ledit conducteur électrique,
- une unité de stockage secondaire d'énergie électrique connectée à ladite unité de stockage principale,
- Une unité de mesure de la tension aux bornes de l'unité de stockage secondaire,
- des deuxièmes moyens de commutation agencés pour être commandés par l'unité de traitement et configurés pour déclencher un transfert d'énergie de ladite unité de stockage principale vers ladite unité de stockage secondaire et pour déclencher une alimentation dudit premier émetteur de données sans-fil lorsque la tension mesurée aux bornes de l'unité de stockage secondaire par ladite unité de mesure dépasse un seuil, pour permettre audit premier émetteur de données sans fil d'émettre un message contenant des données représentatives du courant électrique circulant dans ledit conducteur électrique, sur commande de ladite unité de traitement (UC).

Selon une particularité, l'unité de traitement comporte un microprocesseur et une mémoire non volatile et en ce que le microprocesseur est agencé pour incrémenter un compteur d'énergie à l'issue de de chaque cycle de charge de l'unité de stockage principale.

Selon un mode de réalisation particulier, le dispositif comporte un deuxième émetteur de données sans fil couplé à ladite unité de traitement et le microprocesseur est agencé pour commander l'émission d'un message à l'aide du deuxième émetteur à l'issue d'un cycle de charge de l'unité de stockage principale.

Avantageusement, ce deuxième émetteur est agencé pour fonctionner sur un réseau courte portée choisi parmi Zigbee, ZigBee Green Power, Bluetooth, "Bluetooth Low Energy" ou WiFi.

Avantageusement, le premier émetteur est agencé pour fonctionner sur réseau longue portée de type LPWAN.

Selon l'invention, l'émission d'un message sur un réseau longue portée nécessite une quantité d'énergie importante et il est nécessaire de conserver une solution simple et fiable pour compter l'énergie électrique consommée. L'unité de stockage principale est insuffisante pour fournir l'énergie nécessaire à l'émission d'un message sur le réseau longue portée cependant elle reste nécessaire pour effectuer un comptage simple de l'énergie électrique consommée. Comme le dispositif de l'invention doit rester autonome en énergie électrique, c'est-à-dire ne pas employer de pile électrique ou autre source d'énergie de ce type, il était nécessaire de trouver une solution qui permette de stocker suffisamment d'énergie pour l'émission du message sur le réseau longue portée. La solution de l'invention consiste ainsi à stocker progressivement l'énergie nécessaire à l'émission du message dans une unité de stockage secondaire à partir de l'énergie accumulée à chaque cycle dans l'unité de stockage principale.

L'invention permet ainsi de conserver une solution simple de comptage de l'énergie électrique à l'aide de l'unité de stockage principale, tout en permettant l'émission d'un message sur un réseau longue portée et en conservant un dispositif entièrement autonome.

Préférentiellement, le dispositif de l'invention comporte une unité de décharge connectée à l'unité de stockage principale et commandée par l'unité de traitement pour décharger l'unité de stockage principale (30).

Avantageusement, l'unité de traitement est agencée pour déterminer une donnée représentative d'une durée.

Avantageusement, la donnée représentative d'une durée correspond à un compteur du nombre de cycles de charge de l'unité de stockage principale.

Selon une variante de réalisation, le dispositif comporte une horloge qui permet de déterminer la donnée représentative d'une durée.

Préférentiellement, l'unité de stockage secondaire comporte au moins un super-condensateur.

Selon une autre particularité, le dispositif comporte un circuit redresseur connecté au capteur de courant et destiné à redresser le courant secondaire généré par le capteur de courant.

Avantageusement, le dispositif comporte un circuit de communication en champ proche connectée à une mémoire de l'unité de traitement.

L'invention concerne également un procédé de comptage d'énergie électrique mis en œuvre à l'aide du dispositif tel que défini ci-dessus, le procédé comportant des étapes de :
- Charge de l'unité de stockage principale pour stocker une quantité d'énergie électrique à partir du courant électrique secondaire,
- Transfert d'une énergie électrique de l'unité de stockage principale vers l'unité de stockage secondaire lorsque la tension aux bornes de l'unité de stockage principale atteint un seuil déterminé,
- Emission d'un message à l'aide du premier émetteur lorsqu'une donnée représentative d'une durée a atteint une valeur seuil et lorsque la tension aux bornes de l'unité de stockage secondaire a dépassé un seuil déterminé.

Selon une particularité, la donnée représentative d'une durée correspond à un compteur du nombre de cycles de charge de l'unité de stockage principale.

Selon une variante de réalisation particulière, la donnée représentative d'une durée correspond à une durée écoulée déterminée à l'aide d'une horloge.

Préférentiellement, le procédé comporte une étape de décharge de l'unité de stockage principale mise en œuvre après l'étape de transfert d'énergie de l'unité de stockage principale vers l'unité de stockage secondaire ou d'émission d'un message.

### Brève description des figures

D'autres caractéristiques et avantages vont apparaître dans la description détaillée qui suit, faite en regard des dessins annexés dans lesquels :
- La figure 1 représente de manière schématique un premier mode de réalisation du dispositif de comptage d'énergie électrique de l'invention.
- La figure 2 représente le synoptique de fonctionnement du dispositif de comptage d'énergie électrique de la figure 1.
- Les figures 3A et 3B représentent deux diagrammes temporels illustrant le principe de fonctionnement du dispositif de comptage d'énergie électrique de la figure 1.
- La figure 4 représente de manière schématique un deuxième mode de réalisation du dispositif de comptage d'énergie électrique de l'invention.
- La figure 5 représente le synoptique de fonctionnement du dispositif de comptage d'énergie électrique de la figure 4.
- La figure 6 représente de manière schématique un perfectionnement du dispositif de comptage d'énergie électrique représenté sur la figure 4.
- La figure 7 représente le synoptique de fonctionnement du dispositif de comptage d'énergie électrique de la figure 6.
- La figure 8 représente une variante de réalisation du dispositif de comptage d'énergie électrique représenté sur la figure 6.

### Description détaillée d'au moins un mode de réalisation

Dans la suite de la description, on entend par :
- Courte portée = Short Range - il s'agit de quelques dizaines de mètres en intérieur et jusqu'à 300 mètres en extérieur. Exemple : ZigBee, ZigBee Green Power, Bluetooth, BLE (Bluetooth Low Energy), WiFi.....)
- Longue portée = plusieurs Km. De manière particulière il s'agira de la technologie LPWAN qui inclut par exemple les réseaux de type LoRa et SigFox.

L'invention concerne un dispositif de comptage d'énergie électrique fonctionnant à travers un réseau de communication sans-fil en vue de permettre l'émission de messages, par exemple à destination d'une station centrale destinée à la gestion d'énergie électrique d'un réseau électrique (type "Smart Grid" ou « Smart City »). Préférentiellement, le réseau de communication sera un réseau de communication longue distance et bas-débit de type LPWAN (pour « Low Power Wide Area Network ») et se basant sur un protocole tel que LoRaWAN (« pour Long Range Wide-area network ») ou celui développé par la société SigFox ou Qowisio.

Le dispositif de comptage d'énergie électrique de l'invention se présente par exemple sous la forme d'un boîtier venant se clamper/positionner sur un conducteur électrique 20 et permettant de déterminer des données de mesure liées au courant électrique alternatif circulant dans le conducteur électrique. Préférentiellement, le dispositif de l'invention permet un comptage de l'énergie électrique consommée par l'équipement qui est alimenté par le courant électrique qui circule dans le conducteur électrique 20. Il permet d'envoyer le compteur d'énergie électrique (index d'énergie) et d'autres données telles que le CO, CO2, température, accélération, pression...

En présence d'une horloge de type RTC comme proposé dans l'un des modes de réalisation décrit ci-dessous, le dispositif est en mesure d'envoyer d'autres données représentatives du courant électrique mesuré, notamment :
- La valeur efficace du courant moyen qui circule dans le conducteur électrique 20 ;
- La valeur efficace du courant minimum qui circule dans le conducteur électrique 20 sur une durée de mesure donnée ;
- La valeur efficace du courant maximum qui circule dans le conducteur électrique sur une durée de mesure donnée ;
- La présence d'un défaut de courant (surintensité suivie d'un passage à zéro du courant électrique) ;

Dans la suite de la description, le dispositif sera décrit pour le comptage de l'énergie électrique qui correspond au courant électrique circulant dans le conducteur électrique surveillé.

De manière générale, le dispositif de l'invention fonctionne selon les grands principes suivants :
- Le dispositif de l'invention est par exemple positionné sur un conducteur électrique 20 d'alimentation d'un équipement électrique dans lequel circule un courant Ip.
- Le dispositif de l'invention est auto-alimenté par un courant induit Is issu du courant électrique Ip qui circule dans le conducteur électrique 20.
- Le dispositif comporte une unité de stockage principale 30 d'énergie électrique qui est alimentée par ledit courant induit et qui permet d'alimenter une unité de traitement UC lorsqu'elle comporte suffisamment d'énergie électrique.
- Le dispositif comporte une unité de stockage secondaire 31 d'énergie électrique alimentée par l'unité de stockage principale 30, par envoi d'une commande par l'unité de traitement UC.
- Le dispositif comporte un émetteur 40 alimenté par l'unité de stockage secondaire 31 pour émettre un message sur ledit réseau de communication mentionné ci-dessus lorsque l'unité de stockage secondaire 31 comporte suffisamment d'énergie électrique.

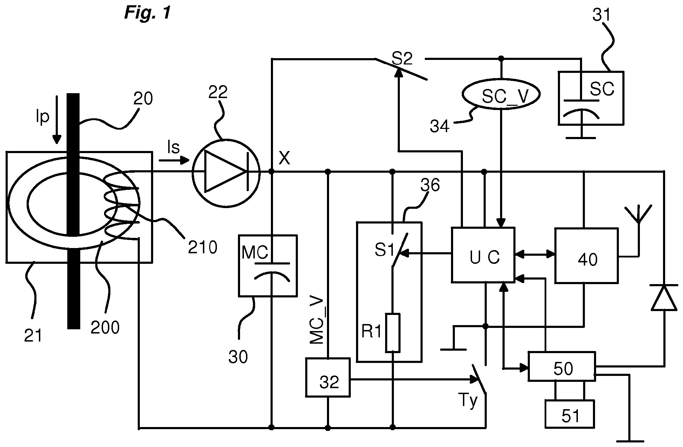

En référence à la figure 1, selon un premier mode de réalisation, le dispositif de comptage d'énergie électrique de l'invention comporte un capteur de courant 21 qui fournit un courant secondaire Is représentatif du courant Ip qui circule dans le conducteur électrique 20. Ce capteur de courant 21 comporte ainsi plus précisément un noyau se présentant sous la forme d'un tore 200 destiné à être traversé par le conducteur électrique 20 dont on cherche à mesurer le courant. Un enroulement 210 est réalisé autour dudit tore 200. Le tore est préférentiellement ouvrant, ce qui lui permet de venir se positionner autour du conducteur électrique 20. Lorsque le capteur de courant 21 est en position sur le conducteur électrique 20, le conducteur électrique 20 forme alors le primaire d'un transformateur de courant et l'enroulement 210 forme le secondaire dudit transformateur de courant. Grâce à cette architecture, le courant Is circulant dans le secondaire du transformateur de courant est l'image du courant Ip circulant dans le primaire du transformateur.

Le dispositif de l'invention comporte également un circuit électronique enfermé dans son boîtier et connecté directement aux deux fils de l'enroulement 210 du secondaire décrit ci-dessus.

Le circuit électronique comporte préférentiellement un redresseur 22 destiné à redresser le courant électrique secondaire Is. Le redresseur 22 sera par exemple composé d'une diode ou pont de diodes connectée sur une première borne de l'enroulement secondaire 210 du transformateur. Il pourra également être constitué d'un pont de diodes connecté entre les deux bornes de l'enroulement secondaire 210 du transformateur.

Le circuit électronique comporte une unité de stockage principale 30 de l'énergie électrique, connectée au redresseur 22 et à une deuxième borne de l'enroulement du secondaire du transformateur de courant. Cette unité comporte au moins un condensateur MC ayant une capacité déterminée.

Le circuit électronique comporte également une unité de détection 32 à seuil de tension connectée en parallèle dudit condensateur et destinée à détecter un dépassement de la tension, désignée MC_V, aux bornes du condensateur MC au-delà d'une valeur seuil déterminée, désignée MC_V_TH

Le circuit électronique comporte des premiers moyens de commutation Ty commandés par l'unité de détection 32 lorsque la valeur seuil de tension MC_V_TH aux bornes dudit condensateur MC est dépassée. Ces premiers moyens de commutation Ty comportent par exemple un thyristor dont la gâchette est connectée sur la sortie de l'unité de détection 32.

Le circuit électronique comporte une unité de stockage secondaire 31 d'énergie électrique, connectée à l'unité de stockage principale 30, plus précisément au point X de jonction entre le redresseur 22 et l'unité de stockage principale 30, et à une référence de tension, par exemple la masse. L'unité de stockage secondaire 31 comporte avantageusement un supercondensateur SC, par exemple de type à double couche (EDLC pour "Electric Double Layer Capacitor") mais, en variante ou en complément, elle peut comporter une batterie.

Le circuit électronique comporte une unité de mesure 34 de la tension, désignée SC_V, aux bornes de l'unité de stockage secondaire 31.

Le circuit électronique comporte une unité de traitement UC, comportant au moins un microprocesseur et une mémoire non volatile, connectée en parallèle de l'unité de stockage principale 30 lorsque les premiers moyens de commutation Ty sont fermés afin de recevoir une alimentation électrique de celle-ci. L'unité de traitement UC comporte une entrée sur laquelle est appliquée la tension mesurée aux bornes de l'unité de stockage secondaire 31 par ladite unité de mesure 34 de la tension. A chaque charge du condensateur MC de l'unité de stockage principale 30, le microprocesseur incrémente un compteur d'énergie d'une quantité définie (désignée ci-dessous "energy_increment") et mémorise ainsi un index d'énergie (désigné "energy_index") qui correspond au cumul d'énergie électrique consommée. La mémoire non volatile de l'unité de traitement UC est avantageusement de type FRAM.

Le circuit électronique comporte des deuxièmes moyens de commutation S2 commandés par l'unité de traitement UC pour un transfert d'énergie de l'unité de stockage principale 30 vers l'unité de stockage secondaire 31. Ces deuxièmes moyens de commutation S2 sont par exemple connectés d'une part à l'unité de stockage principale 30, au point de jonction X avec le redresseur 22, et d'autre part à l'unité de stockage secondaire 31. Il s'agira par exemple d'un interrupteur de type transistor MOS dont la grille est connectée sur une sortie de l'unité de traitement.

Le circuit électronique comporte un émetteur 40 de données sans-fil connecté en parallèle de l'unité de stockage principale 30 lorsque les premiers moyens de commutation Ty sont fermés en vue d'être alimenté par celle-ci. L'émetteur 40 est commandé par l'unité de traitement UC pour l'envoi du message sur le réseau de communication sans-fil tel que celui évoqué ci-dessus. L'émission d'un message a lieu lorsqu'une quantité d'énergie suffisante est disponible dans l'unité de stockage secondaire 31.

Le circuit électronique comporte également une unité de décharge 36 de l'unité de stockage principale connectée en parallèle de l'unité de stockage principale. Cette unité de décharge comporte un ensemble formé d'au moins un interrupteur S1 et d'une résistance de dissipation R1 connectés en série. L'interrupteur est par exemple un transistor dont la base est connectée sur une sortie du microprocesseur de l'unité de traitement UC.

Avantageusement, le circuit électronique comporte également un circuit de communication en champ proche, par exemple de type NFC (pour "Near Field Communication") ou équivalent, comprenant une puce NFC 50 dotée d'une mémoire et d'un microprocesseur et une antenne NFC 51 lui permettant d'être alimenté de l'extérieur, par exemple par un terminal mobile muni de la technologie NFC et d'une application de commande adaptée. Via la liaison en champ proche, le terminal mobile sera ainsi capable d'alimenter directement la puce NFC et l'unité de traitement UC, ainsi que sa mémoire interne non volatile, en vue de copier des données, notamment le compteur d'énergie à jour, stockées dans la mémoire de l'unité de traitement vers la mémoire de la puce NFC. Via la liaison NFC il sera également possible de paramétrer le dispositif de l'invention, par exemple pour fixer les différentes valeurs seuils qui seront décrites ci-dessous.

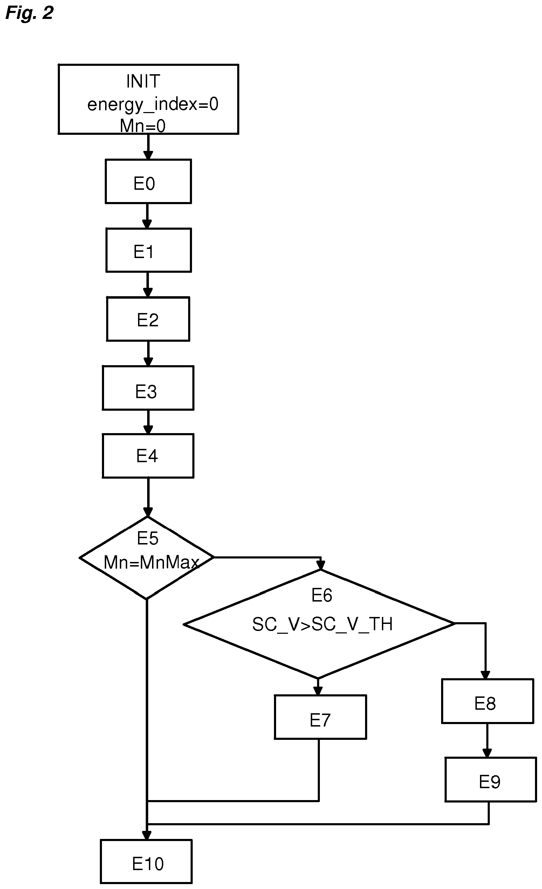

La figure 2 illustre le fonctionnement du dispositif représenté sur la figure 1. Ce fonctionnement est le suivant :
- A la première mise sous tension (INIT), le microprocesseur de l'unité de traitement UC initialise à zéro deux compteurs :
   - Un compteur d'énergie intitulé energy_index, qui correspond à la quantité d'énergie totale consommée par l'équipement alimenté au travers du conducteur électrique 20.
   - Un compteur désigné Mn qui correspond à un compteur de cycles de charge du condensateur de l'unité de stockage principale.
- L'unité de stockage principale 30 est chargée par le courant secondaire induit sur l'enroulement secondaire du capteur de courant 21 et redressé par le redresseur 22 (étape E0).
- Lorsque la tension aux bornes de l'unité de stockage principale 30 atteint le seuil de tension MC_V_TH défini par l'unité de détection 32 à seuil de tension, celle-ci commande les premiers moyens de commutation Ty à la fermeture, entraînant l'alimentation électrique de l'unité de traitement UC (étape E1).
- Le microprocesseur incrémente le compteur d'énergie d'un incrément déterminé (intitulé energy_increment) de sorte que energy_index=energy_index+energy_increment - (étape E2).
- Le microprocesseur de l'unité de traitement UC incrémente d'une unité le compteur Mn de sorte que Mn=Mn+1 (étape E2).
- Le microprocesseur commande également la fermeture des deuxièmes moyens de commutation S2 afin de permettre un transfert d'énergie de l'unité de stockage principale 30 vers l'unité de stockage secondaire 31 (étape E4). La durée de conduction des deuxièmes moyens de commutation S2 est faible par rapport au temps de charge du condensateur MC de l'unité de stockage principale 30. Une fois la durée de conduction achevée, le microprocesseur commande l'ouverture des deuxièmes moyens de commutation S2.
- Le microprocesseur teste la valeur du compteur Mn par rapport à une valeur seuil mémorisée, désignée MnMax (étape E5).
- Si le compteur Mn n'a pas atteint la valeur de MnMax, le microprocesseur termine le cycle en commandant la décharge du condensateur MC de l'unité de stockage principale 30 par fermeture de l'interrupteur S1 de l'unité de décharge 36 (étape E10). Le microprocesseur peut alors débuter un nouveau cycle par la charge du condensateur MC de l'unité de stockage principale 30 (étape E0)
- Si le compteur Mn=MnMax, cela signifie qu'une certaine durée s'est écoulée et qu'il est temps d'envoyer un message. Le microprocesseur effectue alors un test pour savoir si l'énergie électrique disponible dans l'unité de stockage secondaire 31 est suffisante pour l'émission d'un message (étape E6).
- Si la tension SC_V aux bornes de l'unité de stockage secondaire 31 est inférieure à une valeur seuil mémorisée, désignée SC_V_TH, alors le microprocesseur ne peut commander l'émission d'un message. Il décrémente d'une unité le compteur Mn de sorte que Mn=Mn-1 (étape E7). Le microprocesseur termine le cycle en commandant la décharge du condensateur MC de l'unité de stockage principale 30 par fermeture de l'interrupteur S1 de l'unité de décharge 36 (étape E10). Le microprocesseur peut alors débuter un nouveau cycle par la charge du condensateur de l'unité de stockage principale (étape E0).
- Si la tension SC_V aux bornes de l'unité de stockage secondaire 31 est supérieure à la valeur seuil mémorisée SC_V_TH, le microprocesseur réinitialise le compteur Mn à zéro (étape E8) et commande l'émission d'un message (étape E9). Pour cela, le microprocesseur :
   - Commande la fermeture des deuxièmes moyens de commutation S2 en vue d'alimenter l'émetteur 40 à l'aide de l'énergie électrique disponible dans l'unité de stockage secondaire 31.
   - Génère le message à envoyer qui comporte des données représentatives du compteur d'énergie mémorisé energy_index. Le message comporte par exemple un préambule, une donnée de synchronisation, un identifiant du dispositif émetteur ou de la source, des données représentatives dudit compteur d'énergie et une donnée de fin d'émission ou de contrôle. La demande de brevet EP2354799A1 donne l'exemple d'une structure de message d'énergie qui pourrait être généré et émis.
   - Commande l'émetteur 40 pour l'émission du message généré.
- Une fois le message envoyé, le microprocesseur termine le cycle en commandant la décharge du condensateur MC de l'unité de stockage principale 30 par fermeture de l'interrupteur S1 de l'unité de décharge 36 (étape E10). Le microprocesseur peut alors débuter un nouveau cycle par la charge du condensateur MC de l'unité de stockage principale 30 (étape E0).
- A tout moment, si un terminal mobile est approché du dispositif et alimente la puce NFC 50, le compteur d'énergie à jour disponible dans la mémoire non volatile peut être copié dans la mémoire de la puce NFC pour être lu par le terminal mobile (étape E3).

On aura par exemple les données de fonctionnement suivantes :
Ip = 10A
Nombre de spires de l'enroulement secondaire : 3000
Capacité du condensateur MC = 940 µF (condensateur au tantale)
Capacité du super-condensateur SC = 100 mF (condensateur de type EDLC)
Durée d'un cycle de charge du condensateur MC = 1s
T (Durée de conduction de S2) = 2 ms
MnMax = 7200 ( ~ 2 heures)
MC_V_TH = 2.9V
SC_V_TH= 2.8V

Selon l'invention, chaque cycle long à l'issue duquel l'émetteur 40 envoie un message est donc composé de MnMax cycles courts. Ce nombre MnMax est par exemple paramétré dans le dispositif par l'intermédiaire de la liaison NFC décrite ci-dessus. Il doit être fixé en fonction du courant Ip qui alimente l'équipement.

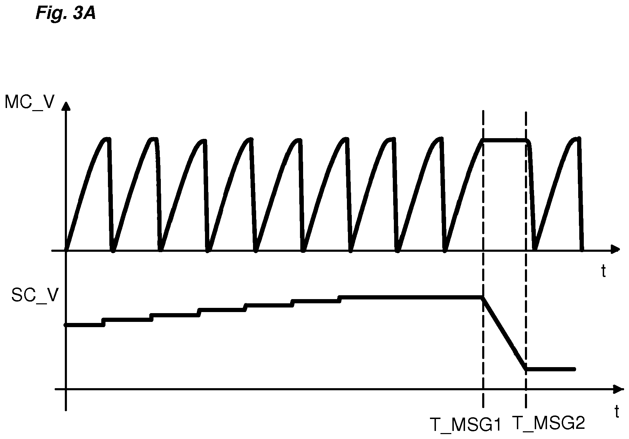

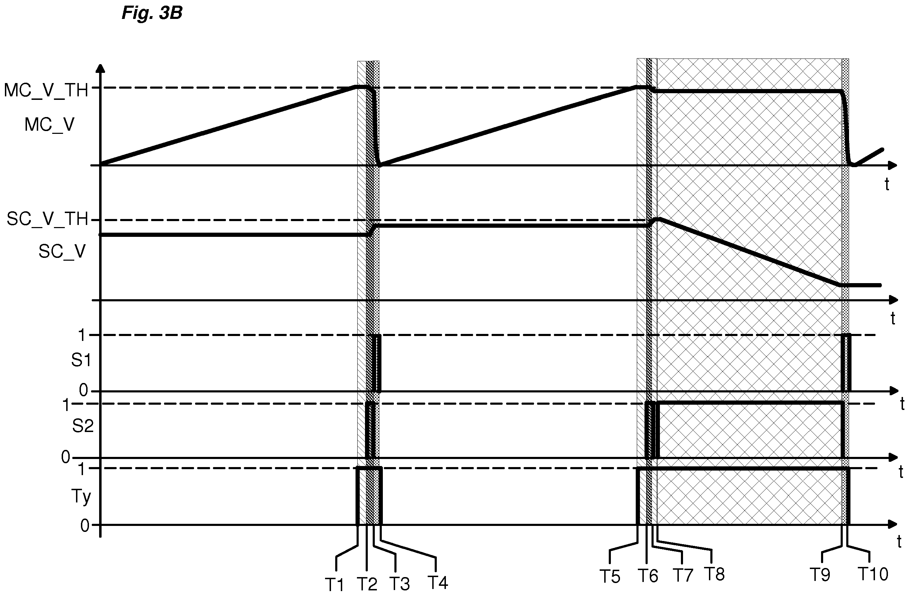

Les figures 3A et 3B illustrent le fonctionnement du dispositif de l'invention tel que celui décrit ci-dessus en liaison avec les figures 1 et 2.

Sur la figure 3A, on comprend bien que le condensateur MC de l'unité de stockage principal 30 est chargé par le courant redressé issu du secondaire du transformateur, permettant d'alimenter l'électronique, notamment l'unité de traitement UC. A l'issue de chaque cycle de charge/décharge du condensateur MC de l'unité de stockage principale 30, une partie de l'énergie accumulée est transférée dans l'unité de stockage secondaire 31 et la tension aux bornes de l'unité de stockage secondaire 31 augmente progressivement. Lorsque cette tension aux bornes de l'unité de stockage secondaire devient suffisante, c'est-à-dire supérieure à la valeur SC_V_TH mémorisée, un message est envoyé à l'instant T_MSG1. L'énergie accumulée dans l'unité de stockage secondaire 31 est alors utilisée pour l'émission du message (de T_MSG1 à T_MSG2).

Sur la figure 3B, on remarque que lorsque l'unité de stockage principale 30 est chargée (de T1 à T3 et de T5 à T7), les premiers moyens de commutation Ty sont à l'état 1 entraînant l'alimentation électrique de l'électronique, et notamment de l'unité de traitement UC. Le microprocesseur de l'unité de traitement UC est donc à même de commander les deuxièmes moyens de commutation S2 de manière à permettre un transfert d'énergie de l'unité de stockage principale vers l'unité de stockage secondaire (de T2 à T3 et de T6 à T7). La tension aux bornes de l'unité de stockage secondaire 31 augmente donc lorsque les deuxièmes moyens de commutation sont fermés. Une fois le transfert d'énergie effectué, le microprocesseur commande l'interrupteur S1 pour décharger le condensateur MC de l'unité de stockage principale 30 (de T3 à T4). Lorsque la tension aux bornes de l'unité de stockage secondaire 31 devient suffisante (à partir de T7), le microprocesseur génère le message à envoyer (de T7 à T8), commande les deuxièmes moyens de commutation S2 à l'état fermé pour décharger l'unité de stockage secondaire 31 (de T8 à T9), permettant ainsi de conserver une tension supérieure au seuil de détection aux bornes de l'unité de stockage principal 30 et ainsi de maintenir les premiers moyens de commutation Ty à l'état fermé pour alimenter l'émetteur et l'unité de traitement UC en vue de l'émission du message (de T8 à T9). Ensuite, le microprocesseur commande l'ouverture de l'interrupteur S2, puis la fermeture de l'interrupteur S1 pour décharger le condensateur MC de l'unité de stockage principale 30 (de T9 à T10).

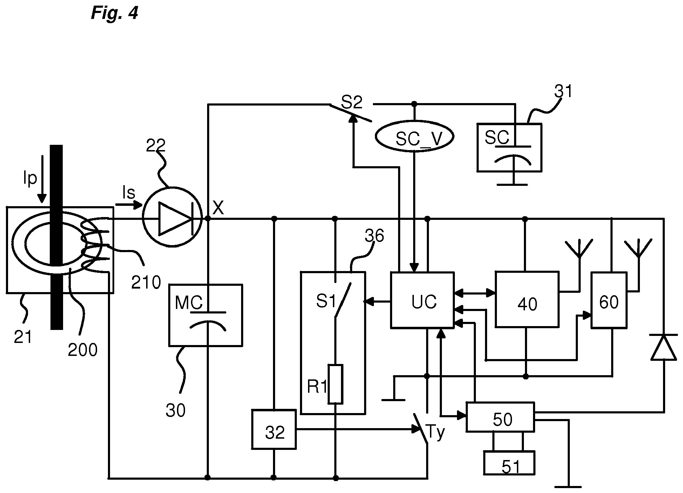

La figure 4 représente un deuxième mode de réalisation du dispositif de comptage d'énergie électrique de l'invention. Dans ce deuxième mode de réalisation, en plus du premier émetteur 40 dédié à la communication sur un réseau longue portée, le dispositif comporte un deuxième émetteur 60 pouvant émettre des données sur un réseau de communication sans-fil de courte portée. Il s'agira par exemple d'un réseau de communication de type radiofréquence fonctionnant sous un protocole basse consommation de type "Zigbee Greenpower". Les autres composants restent inchangés.

Dans ce second mode de réalisation, en partant de la topologie décrite ci-dessus en liaison avec la figure 1, le deuxième émetteur 60 est connecté en parallèle du premier émetteur 40. Cette topologie permet de mettre à profit les deux cycles de charge des deux unités de stockage 30, 31 pour transmettre de l'information sur un réseau longue portée et/ou sur un réseau courte portée. Le cycle court est géré grâce à l'énergie électrique stockée dans l'unité de stockage principale 30 tandis que le cycle long, comme décrit pour le premier mode de réalisation, est géré grâce à l'énergie électrique stockée dans l'unité de stockage secondaire 31. Cette double solution d'émission permet de multiplier les usages du dispositif de l'invention. Selon son implantation et les besoins, le dispositif pourra fonctionner en mode courte portée, en mode longue portée ou en mode combinée courte et longue portée. Dans le mode combiné, il s'agira par exemple de faire remonter des données d'énergie sur le réseau courte portée en temps réel et des données d'énergie et des alarmes sur le réseau longue portée. Ces alarmes pourront être par exemple des niveaux de courant moyen hors gabarit.

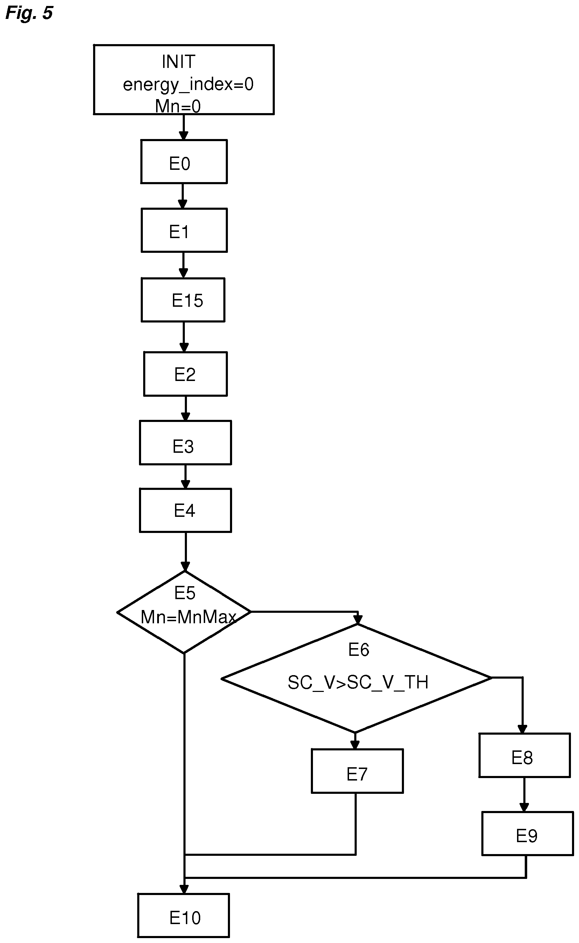

La figure 5 permet de mieux comprendre le fonctionnement du dispositif présentant une topologie à deux émetteurs telle que décrite ci-dessus. Par rapport au synoptique de fonctionnement déjà décrit ci-dessus, une étape d'émission du compteur d'énergie "energy_index" par le deuxième émetteur 60 est commandée par le microprocesseur lorsque l'électronique est alimentée par l'unité de stockage principale 30 (étape E15). Le reste du fonctionnement reste inchangé.

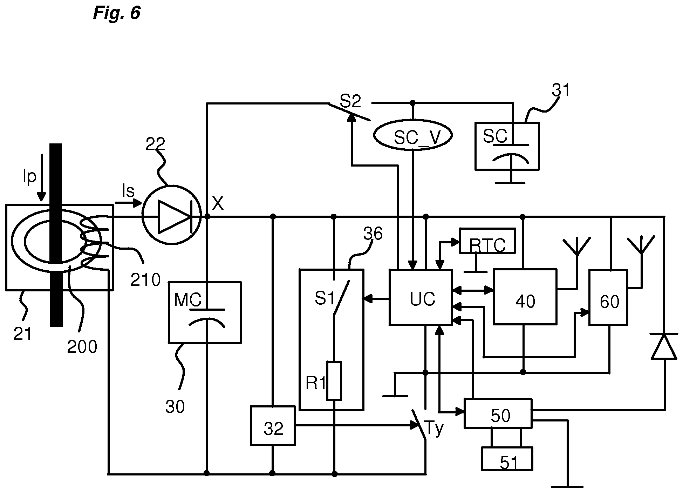

La figure 6 représente un perfectionnement au dispositif représenté sur la figure 4 et décrit ci-dessus. Dans cette nouvelle topologie, le dispositif comporte une horloge (RTC pour "Real Time Clock") afin de mieux régulariser l'envoi des messages. Cette horloge est connectée au microprocesseur et est accessible en lecture et en écriture par le microprocesseur lorsque celui-ci est alimenté. Dans ce mode de réalisation, l'horloge est alimentée par une source d'énergie telle qu'une pile électrique. Dans les solutions décrites ci-dessus, l'émission des messages étaient commandées en suivant le critère du nombre d'un cycle de charge du condensateur grâce au compteur Mn. Grâce à une horloge, l'émission des messages est cadencée suivant un critère temporel. L'utilisation d'une horloge présente notamment un intérêt lorsque les deux émetteurs 40, 60 sont présents mais elle pourrait être employée lorsque seul le premier émetteur de type longue portée est présent. L'emploi d'une horloge est décrit ci-dessous pour une topologie à deux émetteurs telle que celle décrite ci-dessus en liaison avec la figure 4.

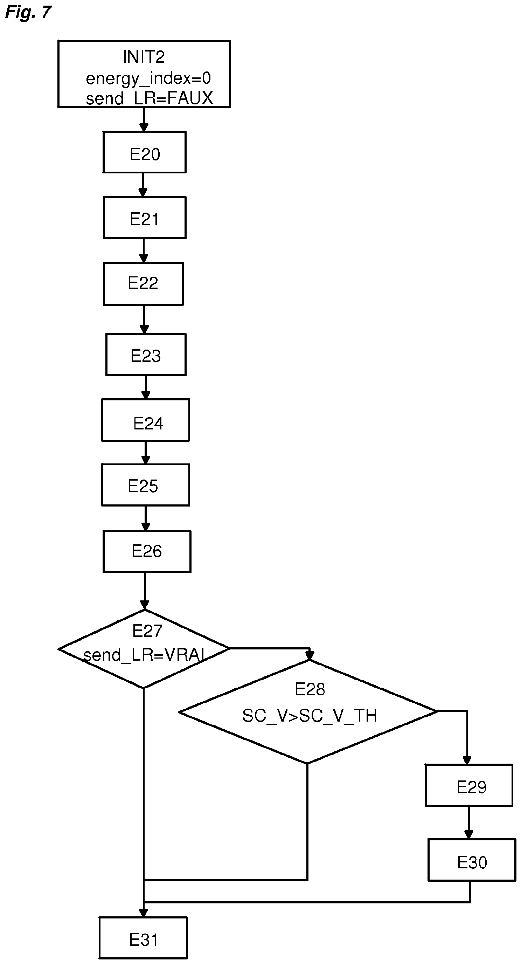

Dans ce mode de réalisation à horloge, le principe de fonctionnement est décrit ci-dessous en liaison avec la figure 7.
- A la première mise sous tension (INIT2), le microprocesseur initialise à zéro le compteur d'énergie de sorte que energy_index=0
- A la première mise sous tension, le microprocesseur initialise une variable désignée "send_LR" à la valeur "Faux".
- L'unité de stockage principale 30 est chargée par le courant secondaire induit sur l'enroulement secondaire du capteur de courant (étape E20).
- Lorsque la tension MC_V aux bornes de l'unité de stockage principale 30 atteint le seuil de tension MC_V_TH défini par l'unité de détection 32 à seuil de tension, celle-ci commande les premiers moyens de commutation Ty à la fermeture, entraînant l'alimentation électrique de l'unité de traitement UC et du deuxième émetteur (étape E21).
- Le microprocesseur incrémente le compteur d'énergie d'un incrément déterminé (intitulé energy_increment) de sorte que energy_index=energy_index+energy_increment - étape E22
- Le microprocesseur génère un message à envoyer qui comporte des données représentatives du compteur d'énergie mémorisé energy_index. Comme décrit précédemment, le message comporte par exemple un préambule, une donnée de synchronisation, un identifiant du dispositif émetteur ou de la source, des données représentatives dudit compteur d'énergie et une donnée de fin d'émission ou de contrôle.
- Le microprocesseur commande le deuxième émetteur 60 courte portée pour l'émission du message généré (étape E24).
- Le microprocesseur consulte ensuite l'horloge RTC. Si l'horloge RTC indique une durée inférieure à une durée limite mémorisée désignée T1 (par exemple égale à 2 heures), le microprocesseur ne fait rien.
- Si l'horloge RTC indique une durée supérieure ou égale à la durée limite mémorisée T1, le microprocesseur attribue la valeur VRAI à la variable send_LR (étape E25).
- Le microprocesseur commande ensuite la fermeture des deuxièmes moyens de commutation S2 afin de permettre un transfert d'énergie de l'unité de stockage principale 30 vers l'unité de stockage secondaire 31 (étape E26). La durée de conduction des deuxièmes moyens de commutation S2 est faible par rapport au temps de charge du condensateur de l'unité de stockage principale. Une fois la durée de conduction achevée, le microprocesseur commande l'ouverture des deuxièmes moyens de commutation S2.
- Le microprocesseur teste la valeur de la variable send_LR (étape E27).
- Si la variable send_LR n'est pas égale à la valeur VRAI, alors le microprocesseur termine le cycle en commandant la décharge du condensateur de l'unité de stockage principale par fermeture de l'interrupteur S1 de l'unité de décharge 36 (étape E31). Le microprocesseur peut alors débuter un nouveau cycle par la charge du condensateur MC de l'unité de stockage principale 31.
- Si la variable send_LR est égale à la valeur VRAI, cela signifie qu'une certaine durée s'est écoulée et qu'il est temps d'envoyer un message. Le microprocesseur effectue alors un test pour savoir si l'énergie électrique disponible dans l'unité de stockage secondaire 31 est suffisante pour l'émission d'un message (étape E28).
- Si la tension aux bornes de l'unité de stockage secondaire 31 est inférieure à une valeur seuil mémorisée, désignée SC_V_TH, alors le microprocesseur ne peut commander l'émission d'un message. Le microprocesseur termine le cycle en commandant la décharge du condensateur de l'unité de stockage principale 30 par fermeture de l'interrupteur de l'unité de décharge (étape E31). Le microprocesseur peut alors débuter un nouveau cycle par la charge du condensateur MC de l'unité de stockage principale 30. Dans cette situation, la variable send_LR reste ainsi à la valeur VRAI au départ du cycle suivant.
- Si la tension SC_V aux bornes de l'unité de stockage secondaire 31 est supérieure à la valeur seuil mémorisée SC_V_TH, le microprocesseur attribue alors la valeur FAUX à la variable send_LR (étape E29) et commande l'émission d'un message (étape E30). Pour cela, le microprocesseur :
   - Commande la fermeture des deuxièmes moyens de commutation S2 en vue d'alimenter l'émetteur 40 à l'aide de l'énergie électrique disponible dans l'unité de stockage secondaire 31.
   - Génère le message à envoyer qui comporte des données représentatives du compteur d'énergie mémorisé energy_index. Le message comporte par exemple un préambule, une donnée de synchronisation, un identifiant du dispositif émetteur ou de la source, des données représentatives dudit compteur d'énergie et une donnée de fin d'émission ou de contrôle.
   - Commande l'émetteur 40 pour l'émission du message généré.
- À tout moment, si un terminal mobile est approché du dispositif et alimente la puce NFC 50, le compteur d'énergie à jour disponible dans la mémoire non volatile de l'unité de traitement UC peut être copié dans la mémoire de la puce NFC pour être lu par le terminal mobile (étape E23).

On aura par exemple les données de fonctionnement suivantes :
Ip = 10A
Nombre de spires de l'enroulement secondaire : 3000
MC = 940 µF (condensateur au tantale)
SC = 100 mF (condensateur de type EDLC)
Durée d'un cycle de charge du condensateur MC = 1s
T (Durée de conduction de S2)= 2 ms
Durée T1 de l'horloge RTC=7200s (~2 heures)
MC_V_TH= 2.9V
SC_V_TH= 2.8V

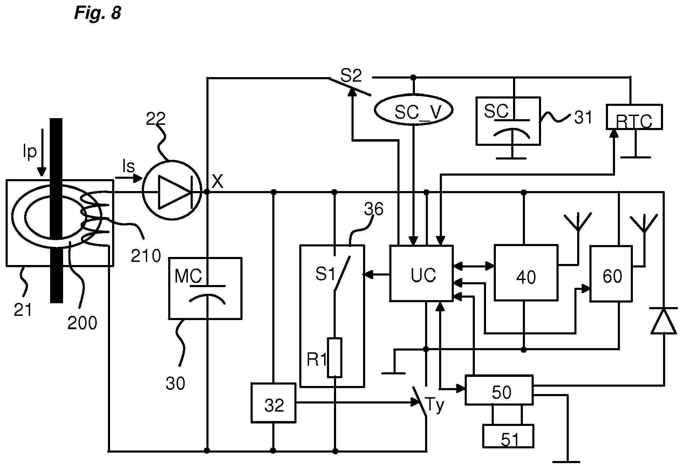

La figure 8 représente une variante de réalisation du dispositif de la figure 6, dans laquelle l'horloge RTC n'est plus alimentée par une pile mais par l'unité de stockage secondaire 31, rendant le dispositif complètement autonome en énergie.

Dans cette solution, l'horloge RTC est connectée en parallèle de l'unité de stockage secondaire 31. Comme précédemment, elle est accessible en lecture et en écriture par le microprocesseur. Comme l'unité de stockage secondaire 31 se décharge lentement, celle-ci peut maintenir une tension aux bornes de l'horloge pour l'alimenter.

Tant que l'unité de stockage secondaire 31 n'a pas été complètement vidée, le fonctionnement du dispositif dans ce mode de réalisation particulier est identique à celui décrit ci-dessus avec une horloge alimentée par une pile. En revanche, si le dispositif n'a pas été actif depuis un certain temps et que l'unité de stockage secondaire 31 est vide, lors de la mise sous tension, le microprocesseur effectue une initialisation de l'horloge. L'instant indiqué par l'horloge sera alors considéré comme l'instant initial à partir duquel la durée T1 mémorisée sera calculée pour déterminer l'instant d'envoi d'un nouveau message sur le réseau longue portée.

La solution de l'invention comporte ainsi de nombreux avantages, parmi lesquels :
- La solution est simple à mettre en oeuvre et fiable. Elle permet ainsi de gérer l'émission d'un message d'énergie sur un réseau longue portée.
- La solution est autonome en ce qu'elle ne nécessite pas l'emploi d'une source d'énergie telle qu'une pile électrique.
- L'émission d'un message d'énergie sur un réseau longue portée ne nécessite pas l'emploi d'une station locale pour centraliser les messages.
- Elle permet de gérer à la fois l'émission d'un message sur un réseau courte portée et/ou sur un réseau longue portée.
- Elle ne nécessite pas forcément l'emploi d'une horloge de type RTC.
- Elle permet d'envoyer directement un message de cumul d'énergie comprenant le dernier index d'énergie calculé. Ainsi, même en cas de rupture de communication, le récepteur reçoit toujours un index à jour.
- Grâce à la liaison NFC, Elle permet un accès direct, à tout moment, à l'index d'énergie à jour et un paramétrage du dispositif.
- Elle permet aussi d'accéder à d'autre grandeurs physiques potentiellement disponibles grâce à des capteurs connectés à l'unité de traitement UC, par exemple, température, humidité, CO, CO2, pression, accélération, ...

## Revendications

1. Dispositif de comptage d'énergie électrique sans-fil comportant :
- Un capteur de courant (21) agencé pour fournir un courant secondaire (ls) à partir d'un courant électrique primaire (lp) circulant dans un conducteur électrique,
- Une unité de stockage principale (30) d'énergie électrique connectée audit capteur de courant et agencée pour stocker une quantité d'énergie électrique à partir du courant électrique secondaire,
- Une unité de détection (32) à seuil de tension connectée à ladite unité de stockage d'énergie électrique principale et agencée pour détecter un dépassement d'un seuil de tension aux bornes de l'unité de stockage d'énergie électrique principale,
- Une unité de traitement (UC) connectée à ladite unité de stockage principale (30),
- Des premiers moyens de commutation (Ty) commandés par l'unité de détection (32) à seuil de tension et configurés pour déclencher une alimentation électrique de l'unité de traitement lorsque ledit seuil de tension aux bornes de l'unité de stockage d'énergie électrique principale est dépassé,
- Un premier émetteur (40) de données sans-fil couplé à ladite unité de traitement et configuré pour envoyer un message contenant des données représentatives du courant électrique circulant dans ledit conducteur électrique,
- Une unité de stockage secondaire (31) d'énergie électrique connectée à ladite unité de stockage principale (30),
- Une unité de mesure (34) de la tension, (SC_V) aux bornes de l'unité de stockage secondaire (31),
- Des deuxièmes moyens de commutation (S2) agencés pour être commandés par l'unité de traitement et configurés pour déclencher un transfert d'énergie de ladite unité de stockage principale (30) vers ladite unité de stockage secondaire (31) et pour déclencher une alimentation dudit premier émetteur de données (40) sans-fil lorsque la tension mesurée aux bornes de l'unité de stockage secondaire (31) par ladite unité de mesure (34) dépasse un seuil, pour permettre audit premier émetteur de données sans fil d'émettre un message contenant des données représentatives du courant électrique circulant dans ledit conducteur électrique, sur commande de ladite unité de traitement (UC).

2. Dispositif selon la revendication 1, **caractérisé en ce que** l'unité de traitement comporte un microprocesseur et une mémoire non volatile et **en ce que** le microprocesseur est agencé pour incrémenter un compteur d'énergie à l'issue de de chaque cycle de charge de l'unité de stockage principale (30).

3. Dispositif selon la revendication 2, **caractérisé en ce qu'**il comporte un deuxième émetteur (60) de données sans fil couplé à ladite unité de traitement (UC) et **en ce que** le microprocesseur est agencé pour commander l'émission d'un message à l'aide du deuxième émetteur à l'issue d'un cycle de charge de l'unité de stockage principale (30).

4. Dispositif selon la revendication 3, **caractérisé en ce que** le deuxième émetteur (60) est agencé pour fonctionner sur un réseau courte portée, choisi parmi Zigbee, ZigBee Green Power, Bluetooth, "Bluetooth Low Energy" ou WiFi.

5. Dispositif selon l'une des revendications 1 à 4, **caractérisé en ce que** le premier émetteur est agencé pour fonctionner sur réseau longue portée de type LPWAN.

6. Dispositif selon l'une des revendications 1 à 5, **caractérisé en ce qu'**il comporte une unité de décharge connectée à l'unité de stockage principale et commandée par l'unité de traitement pour décharger l'unité de stockage principale (30).

7. Dispositif selon l'une des revendications 1 à 6, **caractérisé en ce que** l'unité de traitement (UC) est agencée pour déterminer une donnée représentative d'une durée.

8. Dispositif selon la revendication 7, **caractérisé en ce que** la donnée représentative d'une durée correspond à un compteur du nombre de cycles de charge de l'unité de stockage principale (30).

9. Dispositif selon la revendication 7, **caractérisé en ce que** le dispositif comporte une horloge qui permet de déterminer la donnée représentative d'une durée.

10. Dispositif selon l'une des revendications 1 à 9, **caractérisé en ce que** l'unité de stockage secondaire comporte au moins un super-condensateur.

11. Dispositif selon l'une des revendications 1 à 10, **caractérisé en ce qu'**il comporte un circuit redresseur (22) connecté au capteur de courant (21) et destiné à redresser le courant secondaire généré par le capteur de courant (21).

12. Dispositif selon l'une des revendications 1 à 11, **caractérisé en ce qu'**il comporte un circuit de communication en champ proche (50, 51) connectée à une mémoire de l'unité de traitement (UC).

13. Procédé de comptage d'énergie électrique mis en œuvre à l'aide du dispositif tel que défini dans l'une des revendications 1 à 12, **caractérisé en ce qu'**il comporte des étapes de :
- Charge de l'unité de stockage principale (30) pour stocker une quantité d'énergie électrique à partir du courant électrique secondaire,
- Transfert d'une énergie électrique de l'unité de stockage principale (30) vers l'unité de stockage secondaire (31) lorsque la tension aux bornes de l'unité de stockage principale (30) atteint un seuil déterminé (MC_V_TH),
- Emission d'un message à l'aide du premier émetteur (40) lorsqu'une donnée représentative d'une durée a atteint une valeur seuil et lorsque la tension aux bornes de l'unité de stockage secondaire (31) a dépassé un seuil déterminé (SC_V_TH).

14. Procédé selon la revendication 13, **caractérisé en ce que** la donnée représentative d'une durée correspond à un compteur du nombre de cycles de charge de l'unité de stockage principale (30).

15. Procédé selon la revendication 13, **caractérisé en ce que** la donnée représentative d'une durée correspond à une durée écoulée déterminée à l'aide d'une horloge.

16. Procédé selon l'une des revendications 13 à 15, **caractérisé en ce qu'**il comporte une étape de décharge de l'unité de stockage principale (30) mise en œuvre après l'étape de transfert d'énergie de l'unité de stockage principale (30) vers l'unité de stockage secondaire ou d'émission d'un message.

## Patentansprüche

1. Drahtlose Zählvorrichtung elektrischer Energie, die aufweist:
- einen Stromabnehmer (21), der eingerichtet ist, einen Sekundärstrom (ls) ausgehend von einem elektrischen Primärstrom (lp) zu liefern, der in einem elektrischen Leiter fließt,
- eine Hauptspeichereinheit (30) elektrischer Energie, die mit dem Stromabnehmer verbunden und eingerichtet ist, eine Menge elektrischer Energie ausgehend vom elektrischen Sekundärstrom zu speichern,
- eine Erfassungseinheit (32) mit Spannungsschwelle, die mit der Hauptspeichereinheit elektrischer Energie verbunden und eingerichtet ist, ein Überschreiten einer Spannungsschwelle an den Klemmen der Hauptspeichereinheit elektrischer Energie zu erfassen,
- eine Verarbeitungseinheit (UC), die mit der Hauptspeichereinheit (30) verbunden ist,
- erste Schalteinrichtungen (Ty), die von der Erfassungseinheit (32) mit Spannungsschwelle gesteuert werden und konfiguriert sind, eine Stromversorgung der Verarbeitungseinheit auszulösen, wenn die Spannungsschwelle an den Klemmen der Hauptspeichereinheit elektrischer Energie überschritten ist,
- einen ersten drahtlosen Datensender (40), der mit der Verarbeitungseinheit gekoppelt und konfiguriert ist, eine Nachricht zu schicken, die für den im elektrischen Leiter fließenden elektrischen Strom repräsentative Daten enthält,
- eine Sekundärspeichereinheit elektrischer Energie (31), die mit der Hauptspeichereinheit (30) verbunden ist,
- eine Messeinheit (34) der Spannung (SC_V) an den Klemmen der Sekundärspeichereinheit (31),
- zweite Schalteinrichtungen (S2), die eingerichtet sind, von der Verarbeitungseinheit gesteuert zu werden, und konfiguriert sind, einen Energietransfer von der Hauptspeichereinheit (30) zur Sekundärspeichereinheit (31) auszulösen und eine Versorgung des ersten drahtlosen Datensenders (40) auszulösen, wenn die an den Klemmen der Sekundärspeichereinheit (31) durch die Messeinheit (34) gemessene Spannung eine Schwelle überschreitet, um es dem ersten drahtlosen Datensender zu ermöglichen, eine Nachricht zu senden, die für den im elektrischen Leiter fließenden elektrischen Strom repräsentative Daten enthält, auf Befehl der Verarbeitungseinheit (UC).

2. Vorrichtung nach Anspruch 1, **dadurch gekennzeichnet, dass** die Verarbeitungseinheit einen Mikroprozessor und einen nicht-flüchtigen Speicher aufweist, und dass der Mikroprozessor eingerichtet ist, am Ende jedes Ladezyklus der Hauptspeichereinheit (30) einen Energiezähler zu inkrementieren.

3. Vorrichtung nach Anspruch 2, **dadurch gekennzeichnet, dass** sie einen zweiten drahtlosen Datensender (60) aufweist, der mit der Verarbeitungseinheit (UC) gekoppelt ist, und dass der Mikroprozessor eingerichtet ist, das Senden einer Nachricht mit Hilfe des zweiten Senders am Ende eines Ladezyklus der Hauptspeichereinheit (30) zu steuern.

4. Vorrichtung nach Anspruch 3, **dadurch gekennzeichnet, dass** der zweite Sender (60) eingerichtet ist, in einem Nahbereichsnetz zu arbeiten, das ausgewählt wird aus Zigbee, ZigBee Green Power, Bluetooth, "Bluetooth Low Energy" oder WiFi.

5. Vorrichtung nach einem der Ansprüche 1 bis 4, **dadurch gekennzeichnet, dass** der erste Sender eingerichtet ist, im Fernbereichsnetz der Art LPWAN zu arbeiten.

6. Vorrichtung nach einem der Ansprüche 1 bis 5, **dadurch gekennzeichnet, dass** sie eine Entladeeinheit aufweist, die mit der Hauptspeichereinheit verbunden ist und von der Verarbeitungseinheit gesteuert wird, um die Hauptspeichereinheit (30) zu entladen.

7. Vorrichtung nach einem der Ansprüche 1 bis 6, **dadurch gekennzeichnet, dass** die Verarbeitungseinheit (UC) eingerichtet ist, einen für eine Dauer repräsentativen Datenwert zu bestimmen.

8. Vorrichtung nach Anspruch 7, **dadurch gekennzeichnet, dass** der für eine Dauer repräsentative Datenwert einem Zähler der Anzahl von Ladezyklen der Hauptspeichereinheit (30) entspricht.

9. Vorrichtung nach Anspruch 7, **dadurch gekennzeichnet, dass** die Vorrichtung einen Taktgeber aufweist, der es ermöglicht, den für eine Dauer repräsentativen Datenwert zu bestimmen.

10. Vorrichtung nach einem der Ansprüche 1 bis 9, **dadurch gekennzeichnet, dass** die Sekundärspeichereinheit mindestens einen Superkondensator aufweist.

11. Vorrichtung nach einem der Ansprüche 1 bis 10, **dadurch gekennzeichnet, dass** sie eine Gleichrichterschaltung (22) aufweist, die mit dem Stromabnehmer (21) verbunden und dazu bestimmt ist, den vom Stromabnehmer (21) erzeugten Sekundärstrom gleichzurichten.

12. Vorrichtung nach einem der Ansprüche 1 bis 11, **dadurch gekennzeichnet, dass** sie eine Nahfeld-Kommunikationsschaltung (50, 51) aufweist, die mit einem Speicher der Verarbeitungseinheit (UC) verbunden ist.

13. Zählverfahren elektrischer Energie, das mit Hilfe der Vorrichtung durchgeführt wird, wie sie in einem der Ansprüche 1 bis 12 definiert ist, **dadurch gekennzeichnet, dass** es Schritte aufweist des:
- Ladens der Hauptspeichereinheit (30), um ausgehend vom elektrischen Sekundärstrom eine Menge elektrischer Energie zu speichern,
- Transfers einer elektrischen Energie von der Hauptspeichereinheit (30) zur Sekundärspeichereinheit (31), wenn die Spannung an den Klemmen der Hauptspeichereinheit (30) eine bestimmte Schwelle (MC_V_TH) erreicht,
- Sendens einer Nachricht mit Hilfe des ersten Senders (40), wenn ein für eine Dauer repräsentativer Datenwert einen Schwellwert erreicht hat, und wenn die Spannung an den Klemmen der Sekundärspeichereinheit (31) eine bestimmte Schwelle (SC_V_TH) überschritten hat.

14. Verfahren nach Anspruch 13, **dadurch gekennzeichnet, dass** der für eine Dauer repräsentative Datenwert einem Zähler der Anzahl von Ladezyklen der Hauptspeichereinheit (30) entspricht.

15. Verfahren nach Anspruch 13, **dadurch gekennzeichnet, dass** der für eine Dauer repräsentative Datenwert einer abgelaufenen Dauer entspricht, die mit Hilfe eines Taktgebers bestimmt wird.

16. Verfahren nach einem der Ansprüche 13 bis 15, **dadurch gekennzeichnet, dass** es einen Schritt des Entladens der Hauptspeichereinheit (30) aufweist, der nach dem Schritt des Energietransfers von der Hauptspeichereinheit (30) zur Sekundärspeichereinheit oder des Sendens einer Nachricht durchgeführt wird.

## Claims

1. Wireless electrical energy metering device comprising:
- a current sensor (21) designed to supply a secondary current (Is) from a primary electric current (Ip) flowing through an electrical conductor;
- a primary electrical energy storage unit (30) connected to said current sensor and designed to store an amount of electrical energy from the secondary electric current;
- a voltage threshold detection unit (32) connected to said primary electrical energy storage unit and designed to detect an exceedance of a voltage threshold at the terminals of the primary electrical energy storage unit;
- a processing unit (UC) connected to said primary storage unit (30);
- first switching means (Ty) controlled by the voltage threshold detection unit (32) and configured to trigger a supply of electric power to the processing unit when said voltage threshold at the terminals of the primary electrical energy storage unit is exceeded;
- a first wireless data transmitter (40) connected to said processing unit and configured to send a message containing data representing the electric current flowing through said electrical conductor;
- a secondary electrical energy storage unit (31) connected to said primary storage unit (30);
- a unit (34) for measuring the voltage (SC_V) at the terminals of the secondary storage unit (31);
- second switching means (S2) designed to be controlled by the processing unit and configured to trigger a transfer of energy from said primary storage unit (30) to said secondary storage unit (31) and to trigger a supply of power to said first wireless data transmitter (40) when the voltage measured at the terminals of the secondary storage unit (31) by said measurement unit (34) exceeds a threshold, with a view to allowing said first wireless data transmitter to transmit a message containing data representing the electric current flowing through said electrical conductor, upon instruction from said processing unit (UC).

2. Device according to Claim 1, **characterized in that** the processing unit comprises a microprocessor and a non-volatile memory and **in that** the microprocessor is designed to increment an energy meter on completion of each charging cycle of the primary storage unit (30).

3. Device according to Claim 2, **characterized in that** it comprises a second wireless data transmitter (60) connected to said processing unit (UC) and **in that** the microprocessor is designed to instruct a message to be transmitted using the second transmitter on completion of a charging cycle of the primary storage unit (30).

4. Device according to Claim 3, **characterized in that** the second transmitter (60) is designed to operate on a short-range network, selected from Zigbee, ZigBee Green Power, Bluetooth, "Bluetooth Low Energy" or Wi-Fi.

5. Device according to any of Claims 1 to 4, **characterized in that** the first transmitter is designed to operate on a long-range network of LPWAN type.

6. Device according to any of Claims 1 to 5, **characterized in that** it comprises a discharging unit connected to the primary storage unit and instructed by the processing unit to discharge the primary storage unit (30).

7. Device according to any of Claims 1 to 6, **characterized in that** the processing unit (UC) is designed to determine a data item representing a duration.

8. Device according to Claim 7, **characterized in that** the data item representing a duration corresponds to a meter of the number of charging cycles of the primary storage unit (30).

9. Device according to Claim 7, **characterized in that** the device comprises a clock that allows the data item representing a duration to be determined.

10. Device according to any of Claims 1 to 9, **characterized in that** the secondary storage unit comprises at least one super-capacitor.

11. Device according to any of Claims 1 to 10, **characterized in that** it comprises a rectifier circuit (22) connected to the current sensor (21) and intended to rectify the secondary current generated by the current sensor (21).

12. Device according to any of Claims 1 to 11, **characterized in that** it comprises a near field communication circuit (50, 51) connected to a memory of the processing unit (UC).

13. Electrical energy metering method implemented using the device as defined in any of Claims 1 to 12, **characterized in that** it comprises the following steps:
- charging the primary storage unit (30) to store an amount of electrical energy from the secondary electric current;
- transferring electrical energy from the primary storage unit (30) to the secondary storage unit (31) when the voltage at the terminals of the primary storage unit (30) reaches a determined threshold (MC_V_TH);
- transmitting a message using the first transmitter (40) when a data item representing a duration has reached a threshold value and when the voltage at the terminals of the secondary storage unit (31) has exceeded a determined threshold (SC_V_TH).

14. Method according to Claim 13, **characterized in that** the data item representing a duration corresponds to a meter of the number of charging cycles of the primary storage unit (30).

15. Method according to Claim 13, **characterized in that** the data item representing a duration corresponds to an elapsed duration determined using a clock.

16. Method according to any of Claims 13 to 15, **characterized in that** it comprises a step of discharging the primary storage unit (30) that is implemented after the step of transferring energy from the primary storage unit (30) to the secondary storage unit or of transmitting a message.
